# EUROPÄISCHE PATENTSCHRIFT

(11) **EP 2 556 299 B1**
(45) Veröffentlichungstag und Bekanntmachung des Hinweises auf die Patenterteilung: **02.01.2019**
(21) Anmeldenummer: 11714023.6
(22) Anmeldetag: 08.04.2011
(51) Int. Cl.: F21V 21/096, H01L 51/52, H01L 25/04, H05K 3/30, F21Y 105/00

(54) **FLÄCHIGE LEUCHTKÖRPER UND ANORDNUNG VON FLÄCHIGEN LEUCHTKÖRPERN**
FLAT LIGHTING ELEMENTS AND ARRAY OF FLAT LIGHTING ELEMENTS
CORPS LUMINESCENTS PLATS ET DISPOSITIF DE CORPS LUMINESCENTS PLATS

(30) Priorität: 10.04.2010 DE 102010014613; 09.04.2010 EP 10003828
(43) Veröffentlichungstag der Anmeldung: 13.02.2013
(73) Patentinhaber: Tridonic GmbH & Co KG, 6851 Dornbirn (AT)
(72) Erfinder: KIRCHHOF, Christian, 01099 Dresden (DE); AMELUNG, Jörg, 01099 Dresden (DE)
(74) Vertreter: Thun, Clemens
(86) Internationale Anmeldenummer: PCT/EP2011/055529
(87) Internationale Veröffentlichungsnummer: WO 2011/124692

(56) Entgegenhaltungen:
- EP-A1- 1 367 674
- WO-A1-2008/099305
- WO-A1-2008/099306
- DE-T2- 69 332 780
- US-A1- 2005 184 662
- US-A1- 2006 092 641
- US-A1- 2009 154 513

## Beschreibung

Die vorliegende Erfindung bezieht sich auf flächige Leuchtkörper und eine Anordnung von flächigen Leuchtkörpern. Auf der Basis organischer Leuchtdioden (OLED = Organic Light Emitting Diode) können neuartige Leuchtelemente verwirklicht werden. Als flächige Leuchtkörper, die gegenüber anorganischen LEDs (LED = Light Emitting Diode) eine moderate Leuchtdichte aufweisen, sind OLEDs ideal geeignet für die Herstellung flächiger diffuser Lichtquellen, wie bspw. Leuchtpanels. Großflächige, diffus abstrahlende Lichtquellen sind insbesondere für Anwendungen in der allgemeinen Beleuchtung erwünscht und daher haben OLEDs vielversprechendes Zukunftspotential in diesen Anwendungsfeldern. In Folge der verwendeten Dünnschichttechnologie bei der Herstellung von OLEDs kann es ferner möglich werden, flexible Leuchtkörper zu realisieren, die bisher nicht bekannte Möglichkeiten zur Beleuchtung von Räumen eröffnen.
Analog zu anorganischen LEDs sind OLEDs stromgetriebene Bauelemente, d.h. die Leuchtdichte der OLED ist mit dem durch die lichtemittierende, aktive Schicht der OLED fließenden Strom korreliert. Um eine über ihre Abstrahlfläche gleichmäßig leuchtende OLED zu realisieren, ist es erforderlich, eine über die Fläche der OLED homogene Stromdichteverteilung bereitzustellen. Dies stellt aber insbesondere bei der Herstellung großflächiger Leuchtelemente eine Herausforderung dar. Typischerweise weist eine OLED mindestens eine transparente Elektrode auf, die beispielsweise mittels eines transparenten leitfähigen Oxids (TCO = Transparent Conductive Oxide) oder mittels durchsichtiger Metallschichten realisiert wird. Da die elektrische Leitfähigkeit dieser transparenten Elektrodenmaterialien allerdings gering ist, ist die Homogenität der Stromdichteverteilung limitiert. Bei geforderter Homogenität der Leuchtdichte ist dadurch die maximal erreichbare Leuchtflächengröße beschränkt. Aus diesem Grund ist es häufig erforderlich, größere Leuchtflächen in Segmente oder Einzelflächen zu unterteilen. Für eine größere Leuchtfläche sind somit mehrere Einzelleuchtelemente zusammenzuschließen, wobei ein elektrisches Kontaktierungssystem erforderlich ist, um eine effiziente Ansteuerung großflächiger OLED-Leuchtflächen zu ermöglichen. Dieses Kontaktierungssystem sollte so ausgelegt sein, sodass ein Maximum an Leuchtfläche erreicht werden kann. Zusätzlich ist zu beachten, dass die OLED im Betrieb auch Wärme erzeugt, welche abgeführt werden muss. Die Kühlung der OLED sollte dabei derart realisiert werden, dass charakteristische Merkmale wie bspw. die Dünne der OLED erhalten bleiben.

Der Standardaufbau einer konventionellen OLED kann wie folgt zusammengefasst werden. Im Wesentlichen besteht ein OLED-Panel aus zwei flächig ausgebildeten Elektroden (von denen zumindest eine transparent ist), zwischen denen mindestens eine Schicht aus organischen Materialien eingebettet ist. Bei Anlegen einer geeigneten Spannung kann in der aktiven organischen Schicht elektromagnetische Strahlung, vorzugsweise Licht, emittiert werden. Als transparente Elektrode kann beispielsweise Indium-Zinn-Oxid (ITO) mit einer Schichtdicke von ca. 100 nm verwendet werden, wobei häufig die ITO-Schicht auf ein Glassubstrat aufgebracht wird und als Anode dienen kann. Bei der Herstellung eines OLED-Panels wird daran anschließend eine organische Schicht oder eine organische Schichtstruktur, die teilweise bis zu sieben Sublagen oder Schichten aufweisen kann, mit einer Schichtdicke von ca. 100 bis 200 nm aufgebracht. Abschließend wird eine metallische Kathode, die beispielsweise Aluminium aufweisen kann, mit einer Schichtdicke von ca. 100 bis 500 nm Dicke abgeschieden. Bei großflächigen Leuchtelementen führt der hochohmige Widerstand der ITO-Schicht zu einer Inhomogenität der Stromeinspeisung. So kann der hochohmige Widerstand der ITO-Schicht beispielsweise einen Wert von ca. 10 bis 20 Ohm/square (square = Quadratfläche) aufweisen. Eine Ursache für die Inhomogenität ist beispielsweise, dass die Kontaktierung der ITO-Schicht für die Stromzufuhr oft nur am Rand des Leuchtelements möglich sind. Dies limitiert eine maximal erreichbare Größe für eine gleichmäßig leuchtende OLED auf beispielsweise ca. 50x50 mm².

Um größere Abmessungen zu erreichen, können beispielsweise Metallverstärkungen in Form von Netzen in die ITO-Schicht eingebracht werden. Diese Metallgrids (Metallgitter oder sogenannte Busbars) verringern den effektiven Schichtwiderstand entsprechend deren Belegungsdichte und ermöglichen somit eine Realisierung größerer Diodenflächen. Aufgrund der Nichttransparenz dieser Metallgrids verringert sich jedoch die effektive Leuchtfläche entsprechend. Aus diesem Grund sind Metallgrids beispielsweise nur bis zu ca. 25% der ITO-Fläche überhaupt sinnvoll. Eine mögliche Verbesserung wäre beispielsweise eine Erhöhung der Gridmetalldicke, dies ist aber aufgrund der Strukturierungsmöglichkeiten und der Schichtdicken der organischen Schichten nicht sinnvoll. Eine metallverstärkte ITO-Schicht wird außerdem nur an den Außenkanten kontaktiert, was trotz der effektiven Widerstandsverringerung die maximale Leuchtelementfläche limitiert. Um Einbußen bei der Homogenität der Lichtabstrahlung zu vermeiden, können, wie eingangs erwähnt, große OLED-Flächen in Einzel-OLED-Flächen unterteilt werden.

Bei Standardkontaktkonfigurationen zur Kontaktierung der beiden OLED-Elektroden mit einer Strom-/Spannungsversorgung beziehen sich die Kontaktierungstechniken im Allgemeinen auf das OLED-Panel selbst, also auf das Glassubstrat oder die OLED-Untergrundfolie. Der Kontakt sollte zumindest zweigeteilt sein, da über diese Kontakte der Gesamtstrom für die Anode und Kathode zugeführt oder abgeleitet wird. In einer gängigen Standardform werden zwei sich gegenüberliegende Kanten des OLED-Panels mit der Anode und zwei sich gegenüberliegende Kanten, die sich normal zu den Kanten mit der Anode befinden, mit der Kathode verbunden. Dies führt zu nicht optimalen Anschlüssen, da die Anschlusswiderstände zwischen Kathode und Anode unterschiedlich sind. Weiterhin ist eine solche konventionelle Anordnung der Kontakte nicht verpolungssicher, da beispielsweise eine Drehung eines quadratischen Leuchtpanels um 90° zu einer Verpolung des Leuchtpanels führt. Bei einer Modifikation dieser Kontaktkonfiguration ist nur jeweils ein Kontakt an zwei gegenüberliegenden Seiten eines Panels vorhanden, wie dies beispielsweise in Fig. 7 der EP-A 1-1367674 zu entnehmen ist. Eine andere bekannte Kontaktkonfiguration führt alle Kontakte zu einer Seite eines Leuchtpanels, wie dies beispielsweise den Fig. 2 und 6 der EP-A-1367674 zu entnehmen ist. Um bei dieser Konfiguration eine homogene Lichtverteilung zu erreichen, ist eine seitliche breite Kontaktierungsleitung erforderlich. Dies vermindert jedoch wiederum die Leuchtfläche. Außerdem führen alle diese konventionellen Anschlusskonfigurationen zu einer inhomogenen Stromzuführung, was zu erhöhten Stromdichten in verschiedenen Bereichen (z.B. Punkten oder Linien) führt. Somit ist die Homogenität des Leuchtpanels oder der Leuchtfläche vermindert, da Regionen mit erhöhter Stromzuführung eine höhere Leuchtdichte aufweisen. Daraus resultieren lokal höhere thermische Belastungen, wodurch die Effizienz und Lebensdauer des Leuchtkörpers beeinträchtigt werden kann.

Um die thermische Belastung der Leuchtkörper zu verringern, werden zur Kühlung von OLEDs meistens konventionelle Kühlrippen vorgeschlagen, wie dies beispielsweise in der US-7,329,027 B2 dargestellt ist. Bei der Kontaktierung mehrerer OLED-Panels als OLED-Module ist ferner ein Hauptaugenmerk auf eine einfache Kontaktierung gerichtet. So wird gemäß einer Standardkonfiguration, wie dies beispielsweise in der US-7,271,534 B2 dargestellt ist, eine einfache segmentierte Anschlusskonfiguration verwendet, die aber nicht lösbar ist.

Aus der WO 2008/099306 A1 ist ein Leuchtelement bekannt, das eine OLED aufweist, die auf einem Substrat angeordnet ist, wobei das Substrat in einem Rahmenelement gehaltert ist. Rückseitig weist das Leuchtelement elektrische Kontakte auf, sowie Magnethalter, die zur Verbindung des Leuchtelements mit einem Träger dienen.

Aus der US 2005/0184662 A1 ist ein OLED-Display bekannt, bei dem eine OLED-Schichtanordnung auf einem Substrat angeordnet ist. Das Substrat ist über eine Schicht aus thermischem Klebstoff mit einer Rückenplatte verbunden.

Aus der US 2009/0154513 A1 ist ein Leuchtmodul bekannt, bei dem eine Licht emittierende Diode auf einer Platine angeordnet ist. Zur Kühlung der Diode weist die Platine Bohrungen auf, die mit einem wärmeleitenden Material gefüllt sind.

Ausgehend von diesem Stand der Technik besteht somit ein Bedarf nach einem flächigen Leuchtkörper (OLED-Modul), der sowohl eine effiziente Wärmeableitung als auch eine effiziente, robuste, elektrische und mechanische Verbindung des flächigen Leuchtkörpers mit einer Trägerplatte einer Leuchte oder einer anderen Fassung ermöglicht.

Ausführungsbeispiele der vorliegenden Erfindung schaffen einen flächigen Leuchtkörper nach Anspruch 1 oder eine Anordnung mit einer Vielzahl flächiger Leuchtkörper nach Anspruch 8. Der Kerngedanke der vorliegenden Erfindung besteht darin, ein oder mehrere OLED-Schichtanordnungen (OLED-Panel(s)) mit einem Basiselement wie beispielsweise einer Platine zu verbinden. Diese Anordnung bildet einen flächigen Leuchtkörper (OLED-Modul), der an eine Trägerplatte einer Leuchte lös- oder unlösbar befestigbar ist oder in eine Fassung einsetzbar ist. Dieses OLED-Modul kann nach Bedarf, beispielsweise bei einem Defekt, wieder entnehm- und austauschbar sein. Das Basiselement (Platine) weist dabei Außenkontakte auf, an denen das OLED-Modul bspw. über Federkontakte mit Betriebsstrom versorgt wird. Die Anordnung der Außenkontakte kann dabei standardisiert ausgeführt sein und somit eine für einen Leuchtenhersteller benutzerfreundliche Kontaktierung ermöglichen. Gleichzeitig ist die Funktion des Basiselements, den Strom auf ein oder mehrere Kontaktierungsstellen des OLED-Panels zu verteilen, welche derart am OLED-Panel angeordnet sind, sodass eine möglichst homogene Stromeinspeisung in die flächig ausgebildeten Elektroden des OLED-Panels erzielt wird. Die Kontaktierungsstellen am OLED-Panel können dabei individuell an das jeweils verwendete OLED-Panel angepasst sein. Optional können Logikschaltungen in die Platine integriert sein. Ferner trägt das Basiselement neben der Verdrahtungsfunktion zur mechanischen Stabilisierung des flächigen Leuchtkörpers bei.
Dabei ist gemäß der vorliegenden Erfindung vorgesehen, dass in der Platine an gegenüberliegenden Randabschnitten eine Mehrzahl von Befestigungsmagneten zur mechanischen Befestigung des flächigen Leuchtkörpers an einer Trägerplatte oder in einer Fassung angeordnet sind.
Das OLED-Panel kann insbesondere zur effizienten Wärmeableitung unter Verwendung eines thermisch leitfähigen Klebstoffs mechanisch mit der Platine verbunden sein. Ferner kann auch ein elektrisch leitfähiger Klebstoff zur elektrischen Verbindung des OLED-Panels mit der Platine verwendet werden.

Zur verbesserten Wärmeabfuhr kann das OLED-Modul ferner an dessen Rückseite, an der das OLED-Modul an eine Trägerplatte befestigt bzw. in eine Fassung eingesetzt werden soll, flach ausgebildet sein, um einen engen, flächigen und damit guten thermischen Kontakt mit der Trägerplatte oder Fassung zur effizienten Wärmeableitung zu ermöglichen.

Weiters sind am Basiselement des OLED-Moduls Befestigungsmagnete angeordnet, die eine einfach lösbare Befestigung des OLED-Moduls an die Trägerplatte der Leuchte ohne zusätzliche mechanische Hilfsmittel wie z.B. in Form von Verschraubungen etc. ermöglichen. Insbesondere ermöglicht hierbei eine asymmetrische Anordnung der Befestigungsmagnete am Basiselement, dass der erfindungsgemäße flächige Leuchtkörper verpolungssicher an der Trägerplatte der Leuchte befestig- bzw. in eine Fassung einsetzbar ist. Die Asymmetrie der Anordnung der Befestigungsmagnete kann sich dabei auf die geometrische Anordnung der Befestigungsmagnete beziehen, aber auch auf die jeweils vorhandene magnetische Ausrichtung der einzelnen Befestigungsmagnete. Durch die asymmetrische Anordnung wird erreicht, dass der erfindungsgemäße Leuchtkörper nur in der vorgegeben Einbauposition sicher an eine Trägerplatte angebracht bzw. in einer Fassung eingesetzt werden kann.

Die Verbesserung gegenüber herkömmlichen Leuchtkörpern können somit wie folgt zusammengefasst werden:
- Kontaktierung eines OLED-Panels in Kombination mit einer minimalen Fläche, um eine maximale Leuchtfläche zu erreichen bei gleichzeitiger homogener Stromeinspeisung;
- Aufbau eines effizienten und robusten Kontaktierungssystems inklusive eines robusten Halterungssystems ohne Verschraubung; und
- Integration eines effizienten Kühlungssystems, welches die auftretende Abwärme an eine Trägeplatte des Systems ableitet.

Anzumerken ist, dass bislang die Erfindung immer im Zusammenhang mit OLEDs erläutert wurde. An dieser Stelle soll allerdings explizit darauf hingewiesen werden, dass die erfindungsgemäßen Lösungen keinesfalls auf derartige OLEDs beschränkt sind sondern generell bei allen Arten von flächigen Leuchtkörpern zum Einsatz kommen können. Dies gilt sowohl für den Gedanken der magnetischen Halteelemente als auch für die Verwendung des thermisch leitfähigen Klebstoffs.

Bevorzugte Ausführungsbeispiele der vorliegenden Erfindung werden nachfolgend Bezug nehmend auf die beiliegenden Zeichnungen näher erläutert. Es zeigen:
- Fig. 1: eine Seitenansicht auf einen flächigen Leuchtkörper gemäß Ausführungsbeispielen der vorliegenden Erfindung;
- Fig. 2a-c: schematische Draufsichten auf verschiedene Zwischenflächen des flächigen Leuchtkörpers gemäß Ausführungsbeispielen der vorliegenden Erfindung; und
- Fig. 3a-c: schematische Darstellungen von dreh-invarianten flächigen Leuchtkörpern.

Bevor nachfolgend die vorliegende Erfindung im Detail anhand der Zeichnungen näher erläutert wird, wird darauf hingewiesen, dass funktionsgleiche oder gleichwirkende Elemente in den Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

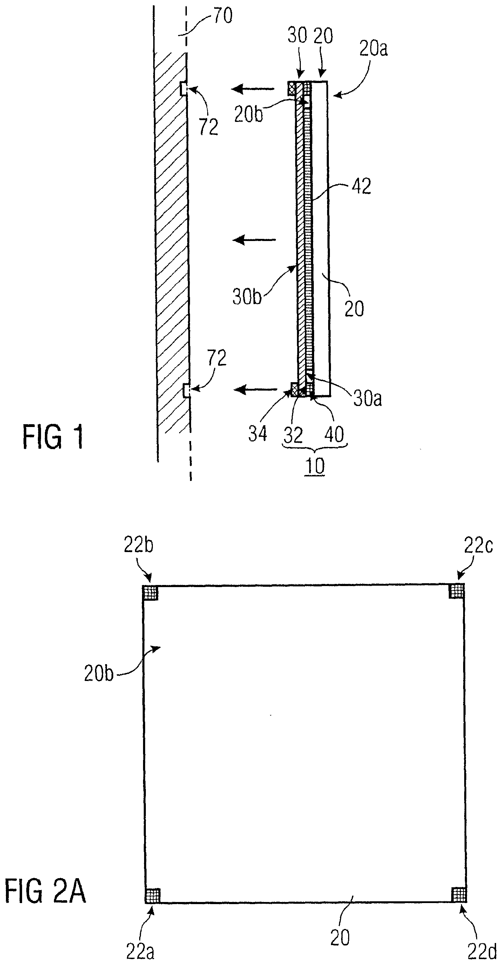

Fig. 1 zeigt nun eine Seitenansicht bzw. Schnittansicht einer Gesamtschichtstruktur eines flächigen Leuchtkörpers 10 (OLED-Modul), während Figuren 2a-c entsprechende, schematische Draufsichten auf verschiedene Oberflächen der Schichtstruktur des erfindungsgemäßen flächigen Leuchtkörpers 10 darstellen. Wie insbesondere den Figuren 2a-c zu entnehmen ist, weist der flächige Leuchtkörper eine quadratische Grundfläche auf, wobei aber gemäß Ausführungsbeispielen der vorliegenden Erfindung eine Vielzahl unterschiedlicher flächiger Grundformen für den flächigen Leuchtkörper verwendet werden können, wie dies die nachfolgenden Ausführungen noch deutlich machen werden.

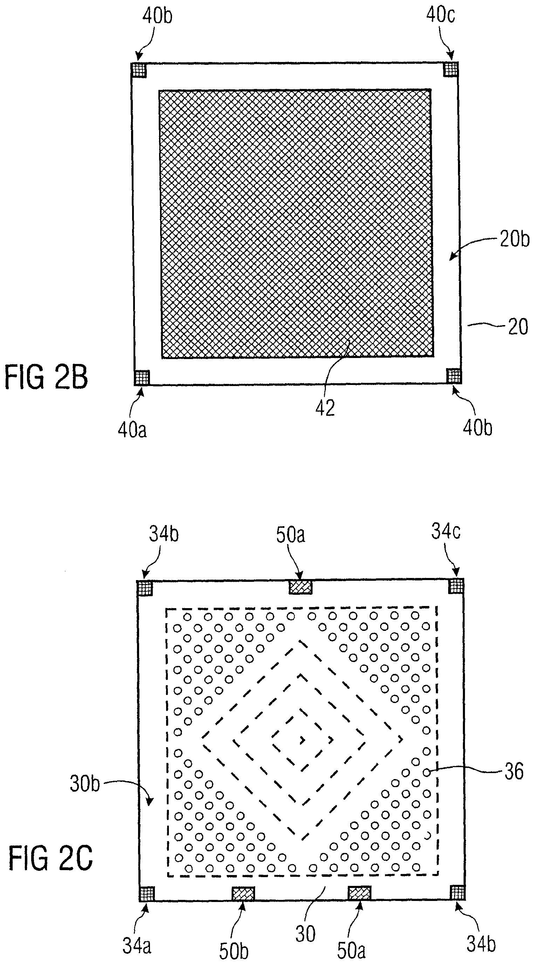

Wie in den Figuren 1 und 2a-c dargestellt ist, weist der flächige Leuchtkörper 10 eine Schichtanordnung 20 (OLED-Panel) mit einer Abstrahloberfläche 20a und einer dazu gegenüberliegenden rückseitigen Oberfläche 20b auf, wobei an einem Randbereich der rückseitigen Oberfläche 20b Kontaktbereiche 22a-d zur elektrischen Kontaktierung der Schichtanordnung 20 angeordnet sind. Fig. 2a stellt somit eine Draufsicht auf die rückseitige Oberfläche 20b der Schichtanordnung 20 dar.
Die Kontaktbereiche 22a-d der Schichtanordnung 20 sind beispielsweise an den Eckpunkten der quadratischen Grundfläche der rückseitigen Oberfläche 20b der Schichtanordnung 20 angeordnet, um beispielsweise eine homogene Stromeinspeisung in die Schichtanordnung 20 zu ermöglichen. Die Schichtanordnung 20 kann in Form einer OLED-Platte oder OLED-Folie vorliegen. Gemäß Ausführungsbeispielen der vorliegenden Erfindung kann die Schichtanordnung 20 beispielsweise eine Anodenschicht, eine Kathodenschicht und eine organische Licht-emittierende Schicht aufweisen, die zwischen der Anodenschicht und der Kathodenschicht angeordnet ist. Die Kontaktbereiche 22a-d an der rückseitigen Oberfläche 20b der Schichtanordnung 20 weisen somit Anodenkontaktbereiche, die die Anodenschicht kontaktieren, und Kathodenkontaktbereiche, die die Kathodenschicht kontaktieren, auf.
Der flächige Leuchtkörper 10 weist ferner ein Basiselement (Platine) 30 mit Kontaktbereichen 32a-d an einer ersten, der Schichtanordnung zugewandten Hauptoberfläche 30a auf, die den Kontaktbereichen 22a-d der Schichtanordnung 20 gegenüberliegen bzw. diesen geometrisch zugeordnet sind. Die Platine 30 weist ferner Außenkontakte 34a-d an einer zweiten Hauptoberfläche 30b auf, wobei die Außenkontakte 34a-d mit den Kontaktbereichen 32a-d auf der ersten Hauptoberfläche 30a durch die Platine 30 hindurch elektrisch verbunden sind. Die Außenkontakte 34a-d sind vorgesehen, um mit einer Trägerplatte 70, beispielsweise einer Leuchte, (oder einer Fassung) und den dortigen Kontakten 72 elektrisch verbunden zu werden.
Bezüglich der Platine 30 wird ferner darauf hingewiesen, dass beispielsweise anstelle der in der Figur 2c dargestellten vier Außenkontakte 34a-d auch beispielsweise nur zwei Außenkontakte an vordefinierten, standardisierten Kontaktierungsstellen vorgesehen sein können, die dann ausgehend von der zweiten Hauptoberfläche 30b der Platine 30 zu vier oder mehr Kontaktbereiche 32a-d auf der ersten Hauptoberfläche 30a der Platine 30 geführt sein können. Damit kann der Betriebsstrom für den flächigen Leuchtkörper 10 von beispielsweise zwei Außenkontakten innerhalb der Platine 30 auf eine größere Anzahl von Kontaktierungsstellen auf die erste Hauptoberfläche 30a der Platine 30 geführt werden, um die OLED-Elektroden, d.h. die Kontaktbereiche 22a-d der Schichtanordnung 20, zu kontaktieren.

Bezüglich der vorliegenden Erfindung wird ferner darauf hingewiesen, dass bezugnehmend auf die Figuren 2a-c jeweils eine Schichtanordnung 20 (OLED-Panel) mit einer Platine 30 verbunden ist, um den flächigen Leuchtkörper 10 (OLED-Modul) zu bilden. Erfindungsgemäß ist es aber gleichermaßen möglich, eine Mehrzahl von Schichtanordnungen 20 jeweils auf einer Platine 30 anzuordnen, um einen flächigen Leuchtkörper 10 mit einer Mehrzahl von Schichtanordnungen 20 zu bilden, der wiederum mit der Trägerplatte befestigbar bzw. in eine Fassung einsetzbar ist.

Die Kontaktbereiche 22a-d der Schichtanordnung 20 sind nun jeweils mittels elektrischer Verbindungselemente 40a-d, wie z.B. mittels elektrischer Druck-, Klemm-, Feder- oder Streckverbindungen oder mittels eines elektrisch leitfähigen Klebstoffes, mit den Kontaktbereichen 32a-d der Platine 30 elektrisch verbunden, wobei die elektrischen Verbindungselemente 40a-d zusätzlich auch eine mechanische Verbindung (zwischen den Kontaktbereichen 22a-d der Schichtanordnung 20 und den Kontaktereichen 32a-d der Platine 30) realisieren können. Ferner ist die rückseitige Oberfläche 20b der Schichtanordnung 20 mittels eines thermisch leitfähigen Klebstoffes 42 mit der der Schichtanordnung 20 zugewandten Hauptoberfläche 30a der Platine 30 verbunden.

Fig. 2b zeigt nun beispielsweise eine Unteransicht auf die rückseitige Oberfläche 20b der Schichtanordnung 20 mit den darauf aufgebrachten elektrischen Verbindungselementen 40a-d und dem thermisch leitfähigen Klebstoff 42, wobei die Verbindungselemente 40a-d beispielsweise als leitfähige Klebstoffbereiche auf den Kontaktbereichen 22a-d der Schichtanordnung 20 ausgebildet sind.

Die Platine 30 kann beispielsweise als Basismaterial ein mit Epoxidharz getränktes Glasfasermaterial (z.B. Materialkennung FR4) oder ein auf Polyimid-basierendes Material aufweisen. Die auf der zweiten Hauptoberfläche 30b der Platine 30 angeordneten Außenkontakte 34a-d sind beispielsweise als robuste elektrische Kontakte für eine lösbare Kontaktierung mit der Trägerplatte 70 oder einer Fassung vorgesehen. So sind beispielsweise auf einer solchen Trägerplatte sogenannte Federkontakte, Steckkontakte, Klemmkontakte etc. vorgesehen, um eine zuverlässige Kontaktierung mit den Außenkontakten 34a-d der Platine 30 zu erhalten.

Wie nun insbesondere Fig. 2c zu entnehmen ist, weist die Platine 30 mit einem thermisch leitfähigen Material gefüllte Durchführungsöffhungen 36 durch die Platine hindurch auf, wobei das thermisch leitfähige Material in den Durchführungsöffnungen 36 mit dem thermisch leitfähigen Klebstoff 42 verbunden bzw. thermisch gekoppelt ist. Wie in Fig. 2c dargestellt ist, sind die mit einem thermisch leitfähigen Material gefüllten Durchführungsöffnungen 36 insbesondere im Bereich der Stromeinspeisungspunkte bzw. Kontakte 22a-d der Schichtanordnung 20 angeordnet. Dies ist vorteilhaft, da organische Leuchtdioden stromgetriebene Bauelemente sind und an den Positionen der Stromeinprägung und Stromauskopplung die höchste thermische Belastung für die Schichtanordnung 20 des flächigen Leuchtkörpers 10 auftritt. Um diese Wärmeentwicklung möglichst gut z.B. auf die Trägerplatte 70 ableiten zu können, sind diese mit einem thermisch leitfähigen Material gefüllte Durchöffnungsöffnungen 36 verstärkt in der Nähe zu den Stromkontaktbereichen 22a-d der Schichtanordnung 20 angeordnet. Dies bedeutet, dass an den mit dem thermisch leitfähigen Klebstoff 42 versehenen Bereichen der Platine 30, die zu den Kontaktbereichen an der rückseitigen Oberfläche 20b der Schichtanordnung 20 benachbart sind, eine größere Anzahl pro Flächeeinheit der mit dem thermisch leitfähigen Material gefüllten Durchführungsöffnungen 36 in der Platine 30 vorgesehen sind als in einem Mittelbereich der Platine 30.

In diesem Zusammenhang wird darauf hingewiesen, dass natürlich auch eine gleichmäßige Verteilung der mit einem thermisch leitfähigen Material gefüllten Durchführungsöffnungen 36 über die gesamte Platine 30 oder auch andere Verteilungen dieser Durchführungsöffnungen 36 vorgesehen sein können, um eine effiziente Wärmeableitung von der Schichtanordnung 20 über die Platine 30 zu der Trägerplatte 70 vorzusehen.

Um eine optimale thermische Ankopplung der Schichtanordnung 20 des flächigen Leuchtkörpers 10 an die Trägerplatte zu erreichen, wird also die Schichtanordnung 20 mit einem thermisch leitfähigen Klebstoff 42 an die Platine 30 geklebt. Um die thermische Ankopplung der Schichtanordnung zu optimieren, wird im thermischen Verteilerbereich zwischen der Schichtanordnung 20 und der Platine 30 die Platine 30 mit elektrischen Durchkontaktierungen 36 versehen, die eine weitaus höhere thermische Leitfähigkeit als das Grundmaterial der Platine 30 aufweisen.

Gemäß Ausführungsbeispielen der vorliegenden Erfindung sind die Durchkontaktierungen oder Vias 36 (Via = vertical interconnect access) der Platine 30 mit einem thermischen leitfähigen Metall, wie z. B. Kupfer, gefüllt. Ein solches Kupfermaterial für die Durchführungen 36 kann beispielsweise noch zumindest teilweise mit Gold oder einem anderem Edelmetall überzogen sein, um eine weiter verbesserte thermische Kopplung mit dem thermisch leitfähigen Klebstoff 42, der die Schichtanordnung 20 mechanisch an der Platine 30 befestigt, zu erhalten. die Durchkontaktierungen 36 kann beispielsweise durch eine innen metallisierte Bohrung in dem Trägermaterial der Platine 30 realisiert sein, die mit dem thermisch leitfähigen Material gefüllt ist. Ferner ist es denkbar, dass beispielsweise auch Nieten oder Stifte als thermisch leitfähiges Material in den Durchkontaktierungen 36 angeordnet und verwendet werden können. Der Durchmesser der Durchkontaktierungen 36 beträgt beispielsweise 0,5 bis 5 mm, wobei pro Flächeneinheit (z. B. 1 cm²) beispielsweise 1 bis 10 Durchführungen 36 in der Platine 30 vorgesehen sein können.
Wie bereits oben angegeben wurde, können die elektrischen Verbindungselemente 40 als Druck-, Klemm-, Feder- oder Steckverbindungen oder auch als ein elektrisch leitfähiger Klebstoff, wie z. B. ein silbergefüllter Epoxidklebstoff, ausgebildet sein. Ferner kann der thermisch leitfähige Klebstoff 42 als ein Epoxidklebstoff ausgebildet sein. Ferner sind die Außenkontakte 34 an der Platine 30, beispielsweise als Feder-, Druck-, Klemm- oder Steckkontakte zur elektrischen Verbindung mit einer Trägerplatte oder Fassung ausgebildet.

Erfindungsgemäß sind in der Platine 30 an gegenüberliegenden Randabschnitten eine Mehrzahl von Befestigungsmagneten 50a-c angeordnet, um eine (von der Seite des OLED-Panels betrachtet) nichtsichtbare, mechanische Verbindung zwischen dem flächigen Leuchtkörper 10 und der Trägerplatte 70 zu erreichen, an der der flächige Leuchtkörper 10 befestigt oder in eine Fassung eingesetzt werden soll. Die Befestigungsmagnete 50a-c können beispielsweise in Ausnehmungen in der Platine 30 angeordnet sein. Es können aber auch Ausnehmungen in der Trägerplatte 70 vorgesehen sein, in die die Befestigungsmagnete eingreifen.
Um einen verpolungssicheren Einbau an der Trägerplatte 70 bzw. in der zugehörigen Fassung zu gewährleisten, können die Befestigungsmagnete 50a-c beispielsweise asymmetrisch zueinander an den gegenüberliegenden Randabschnitten der Platine 30 angeordnet sein. So befinden sich die Befestigungsmagnete 50a-c nur in einer einzigen Einbauposition an den vorgegebenen Befestigungspositionen. Ferner soll sich in den weiteren (möglichen) Einbaupositionen ansonsten zumindest eines oder alle der Befestigungsmagnete 50a-c nicht an einer oder mehreren der vorgegebenen Befestigungspositionen befinden.

Um nun einen verpolungssicheren Einbau an der Trägerplatte 70 bzw. in der zugehörigen Fassung unter Verwendung von Befestigungsmagneten zu gewährleisten, können die Befestigungsmagnete 50a-c beispielsweise asymmetrisch zueinander an den gegenüberliegenden Randabschnitten der Platine 30 angeordnet sein. Falls in der Trägerplatte 70 bzw. Fassung entsprechende Gegenmagnete angeordnet sind, können die Befestigungsmagnete 50a-c mit einer vorgegebenen magnetischen Ausrichtung angeordnet sein, so dass sich die Befestigungsmagnete 50a-c in der Platine 30 und die Gegenmagnete in der Trägerplatte 70 z.B. in der gedachten Einbauposition entsprechend ihrer magnetischen Ausrichtung gegenseitig anziehen oder sich ansonsten in einer der anderen Einbaupositionen voneinander abstoßen.
Bezüglich der vorgegebenen Einbauposition der Befestigungsmagnete an vorgegebenen Magnetpositionen an der Platine 30 ist es also möglich, dass in der Trägerplatte 70 oder Fassung für den flächigen Leuchtkörper 10 entweder geeignete Gegenmagnete oder auch ferromagnetische Metallbereiche zum Ausüben gegenseitiger Anziehungskräfte zu den Befestigungsmagneten 50a-c vorgesehen sein können.

Durch die asymmetrische Anordnung der Befestigungsmagnete wird bewirkt, dass bei einer gegenüber der gewünschten Einbauposition verdrehten Einbauposition eine sichere mechanische Verbindung mit der Trägerplatte bzw. Fassung nicht möglich ist. Es wird dadurch gewährleistet, dass das OLED-Modul nur verpolungssicher eingebaut werden kann.

Der Einsatz der Befestigungsmagnete kann im übrigen auch unabgängig von der Verwendung des zuvor beschriebenen thermisch leitfähigen Klebstoffs erfolgen.
Wie in den Figuren 2a-c dargestellt ist, weist der flächige Leuchtkörper 10 beispielsweise eine quadratische Grundform auf. Die Grundform des flächigen Leuchtkörpers weist somit eine Dreh-Invarianz bzw. Drehsymmetrie gegenüber Drehungen bezüglich einer Achse normal auf die Ebene des flächigen Leuchtkörpers um einen Winkel von α = 90° auf.

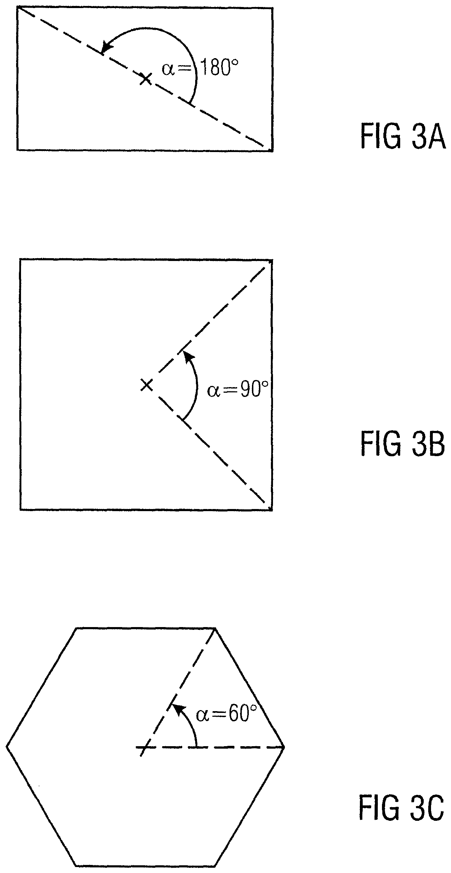

Die Fig. 3a-c zeigen drei weitere Beispiele für die Grundform des Modulkörpers mit unterschiedlicher Drehinvarianz bzw. Drehsymmetrie bezüglich einer Drehung um eine Achse normal auf die Ebene des flächigen Leuchtkörpers um einen Winkel α. Die Drehsymmetrie steht damit in Zusammenhang mit den verschiedenen Möglichkeiten, den flächigen Leuchtkörper vor dem Einsetzen in eine Fassung oder vor dem Anbringen an die Trägerplatte zu drehen. Fig. 3a zeigt eine rechteckige Form, die eine Dreh-Symmetrie von α = 180° aufweist. Fig. 3b zeigt eine quadratische Form, wie sie beispielsweise in den Fig. 1 und 2a-c genutzt wird, welche eine Dreh-Symmetrie bei Drehungen um α = 90° aufweist. Fig. 3c zeigt ein Ausführungsbeispiel, bei dem die Grundform des flächigen Leuchtkörpers als Sechseck ausgebildet ist, so dass sich eine Dreh-Symmetrie von α = 60° ergibt. Auch bei diesen Ausführungsformen können wiederum Kathoden- und Anodenkontaktbereiche an den Eckbereichen bzw. Eckpunkten ausgebildet sein (so wie in Fig. 1 und 2a-c gezeigt) oder können auch entlang der Verbindungslinien zwischen zwei benachbarten Eckpunkten angeordnet sein.
Die hier gezeigten drei Beispiele für Grundformen des flächigen Leuchtkörpers 10 stellen lediglich Beispiele dar, die weiter modifiziert werden können. Beispielsweise können die Ecken des Leuchtkörpers abgeschrägt oder abgerundet sein. Ferner ist es möglich, beispielsweise eine achteckige Form zu wählen, die eine Drehvarianz um 45° aufweist. Insbesondere können reguläre Vielecke für die Grundform des flächigen Leuchtkörpers 10 gewählt werden, wobei ein reguläres oder regelmäßiges Vieleck gleiche Seiten und gleiche Innenwinkel aufweist. Es ist auch möglich, dass der Modulkörper eine andere Grundform als das OLED-Panel aufweist.

Wie bereits im Vorhergehenden angegeben wurde, weist der flächige Leuchtkörper 10 eine Schichtstruktur 20, 30, 40, 42 mit einer Abstrahloberfläche 20a und einer Rückseitenfläche 30b auf, wobei an einem Randbereich der Rückseitenfläche 30b Kontaktbereiche 34 zur Kontaktierung der Schichtstruktur 20, 30, 40, 42 angeordnet sind. Ferner ist eine Mehrzahl von Befestigungsmagneten 50a-c vorgesehen, die in der Platine 30 benachbart zu dem jeweiligen Randbereich angeordnet sind. Die Befestigungsmagnete können nun so an gegenüberliegenden Randabschnitten der Schichtstruktur 20, 30, 40, 42 angeordnet sein, dass sich nur in einer einzigen Einbauposition die Befestigungsmagnete 50a-c an den vorgegebenen Magnetpositionen befinden. In den weiteren Einbaupositionen soll sich keiner der Befestigungsmagnete 50a-c an einer der vorgegebenen Magnetpositionen befinden.
Diese Anordnung der Befestigungsmagnete 50a-c kann beispielsweise durch eine asymmetrische Positionierung dieser Befestigungsmagnete an gegenüberliegenden Randbereichen des flächigen Leuchtkörpers 10 bzw. der Schichtstruktur 20, 30, 40, 42 oder der Platine 30 erreicht werden.
Wie in Fig. 2c beispielhaft dargestellt ist, sind in der quadratischen Platine an einem Randbereich ein Befestigungsmagnet 50a und an dem gegenüberliegenden Randbereich zwei weitere Befestigungsmagnete 50b-c asymmetrisch zueinander angeordnet. Diese Anordnung der Befestigungsmagnete 50a-c ist aber gleichermaßen auf die in den Fig. 3a-c dargestellten flächigen Ausführungsformen des flächigen Leuchtkörpers 10 anwendbar.
Asymmetrisch bedeutet beispielsweise bei Ausführungsbeispielen der vorliegenden Erfindung, dass die Befestigungsmagnete, die sich an gegenüberliegenden Randabschnitten befinden, jeweils an entsprechend unterschiedlichen Positionen zwischen zwei benachbarten Eckpunkten der gegenüberliegenden Randabschnitte angeordnet sind. Somit befindet sich bei einer Drehung des flächigen Leuchtkörpers 10 in eine der weiteren (möglichen) Einbaupositionen keiner der Befestigungsmagnete an einer der vorgegebenen Magnetpositionen.
Neben der asymmetrischen Anordnung der Befestigungsmagnete an Randbereichen des flächigen Leuchtkörpers 10 ist es gemäß weiteren Ausführungsbeispielen der vorliegenden Erfindung möglich, dass zwar die Befestigungsmagnete an vorgegebenen (auch symmetrischen) Magnetpositionen an Randbereichen des flächigen Leuchtkörpers 10 angeordnet sind, wobei aber die Befestigungsmagnete nur in einer einzigen Einbauposition (bezüglich der Drehsymmetrie des flächigen Leuchtkörpers) eine vorgegebene magnetische Ausrichtung bzw. Polarisation aufweisen, und ansonsten in den weiteren, entsprechend der Drehsymmetrie möglichen Einbaupositionen an den vorgegebenen Magnetpositionen eine unterschiedliche magnetische Ausrichtung aufweisen.
Basierend auf dieser weiteren erfindungsgemäßen Ausführungsform wird es ermöglicht, dass sich die Befestigungsmagnete 50a-c und die entsprechenden Gegenmagnete in der Trägerplatte 70 oder Fassung nur in einer einzigen Einbauposition gegenseitig anziehen. Dagegen sollen sich die Befestigungsmagnete 50a-c und die entsprechenden Gegenmagnete in den weiteren Einbaupositionen aufgrund der vorgegeben unterschiedlichen magnetischen Ausrichtung voneinander abstoßen. Bei dem Einsatz von Befestigungsmagneten mit unterschiedlichen magnetischen Ausrichtungen können die Befestigungsmagnete 50a-c beispielsweise auch symmetrisch an dem flächigen Leuchtkörper 10 angeordnet sein, da ein verpolungssicherer Einbau aufgrund der unterschiedlichen magnetischen Ausrichtungen erreicht wird.

Wie bereits oben angegeben wurde, bildet die Schichtstruktur 20, 30, 40, 42 ein reguläres Vieleck, wobei die Befestigungsmagnete 50a-c in gegenüberliegenden Randabschnitten des regulären Vielecks angeordnet sein können. Ferner sollte deutlich werden, dass die Schichtstruktur, wie sie im Vorhergehenden hinsichtlich der Ausführungsbeispiele zur Befestigung des OLED-Moduls 10 an einer Trägerplatte 70 bzw. in einer Fassung mittels Befestigungsmagneten beschrieben wurde, wiederum die Schichtanordnung 20, die Platine 30, die elektrischen Verbindungselemente 40 und den thermisch leitfähigen Klebstoff 42 aufweisen kann. Insbesondere kann auch bei den obigen Ausführungsbeispielen bzgl. der Befestigung mittels Magneten die Platine 30 mit einem thermisch leitfähigen Material gefüllte Durchführungsöffnungen 36 aufweisen, wobei das thermisch leitfähige Material zur effizienten Wärmeableitung mit dem thermisch leitfähigen Klebstoff 42 thermisch gekoppelt ist
Erfindungsgemäß kann nun eine Mehrzahl von flächigen Leuchtkörpern (OLED-Modulen) 10 zu einem Cluster kombiniert sein, um eine regelmäßige Anordnung von flächigen Leuchtkörpern oder OLED-Modulen zu bilden. Dabei sind flächigen Leuchtkörpern (OLED-Modulen) 10 elektrisch parallel oder in Serie verschaltet.

Gemäß der vorliegenden Erfindung ist es also möglich, einen flächigen Leuchtkörper 10 (OLED-Modul) zu bilden, der lösbar und verpolungssicher an eine Trägerplatte bspw. einer Leuchte oder in eine Fassung einsetzbar ist. Eine Vielzahl von flächigen Leuchtkörpern 10 kann wiederum zu einer Anordnung von flächigen Leuchtkörpern mit einer insgesamt großen Abstrahlfläche kombiniert werden. Der erfindungsgemäße Einsatz von Befestigungsmagneten ermöglicht, dass der flächige Leuchtkörper 10 lösbar in eine Fassung eingesetzt werden kann. Dabei ist zu beachten, dass die flächigen Leuchtkörper 10 aufgrund der limitierten Lebensdauer austauschbar ausgelegt sein sollten. Gleichzeitig wird eine verpolungssichere Kontaktierung zwischen dem flächigen Leuchtkörper 10 und dem Stromleitersystem an einer Trägerplatte bzw. Fassung erreicht. Aufgrund der speziellen Ausgestaltung der Platine 30 mit darin angeordneten Durchführungskontakten, die mit einem thermisch leitfähigen Material gefüllt sind, und durch die Verbindung des flächigen Leuchtkörpers 10 mittels eines thermisch leitfähigen Klebstoffes mit der Platine 30 wird ferner eine effiziente Ableitung der Abwärme des Systems beispielsweise zu Kühlträgern ermöglicht, die an der Trägerplatte bzw. Fassung zusätzlich angeordnet sind.

Zusätzlich zu den flächigen Leuchtkörpern 10 umfassen Ausführungsbeispiele der vorliegenden Erfindung ebenfalls ein Verfahren zu deren Herstellung. Das Verfahren umfasst beispielsweise ein Bereitstellen einer Schichtanordnung mit einer Abstrahloberfläche und einer rückseitigen Oberfläche, wobei an einem Randabschnitt der rückseitigen Oberfläche Kontaktbereiche zur Kontaktierung der Schichtanordnung angeordnet sind. Ferner wird eine Platine mit Kontaktbereichen an einer ersten, der Schichtanordnung zugewandeten Hauptoberfläche, die den Kontaktbereichen der Schichtanordnung geometrisch zugeordnet sind bzw. gegenüberliegen, und mit Außenkontakten an einer zweiten Hauptoberfläche, die mit den Kontaktbereichen auf der ersten Hauptoberfläche verbunden sind, bereitgestellt. Daraufhin werden die Kontaktbereiche der Schichtanordnung mittels elektrischer Verbindungselemente mit den Kontaktbereichen der Platine verbunden, wobei ferner die rückseitige Oberfläche der Schichtanordnung mittels eines thermisch leitfähigen Klebstoffes mit der zugewandeten Oberfläche der Platine mechanisch verbunden wird. Dabei weist die Platine beispielsweise mit einem thermisch leitfähigen Material gefüllte Durchführungsöffnungen auf, wobei das thermisch leitfähige Material zur effizienten Wärmeableitung mit dem thermisch leitfähigen Klebstoff thermisch gekoppelt ist.

Abschließend ist nochmals darauf hinzuweisen, dass die zuvor beschriebenen erfindungsgemäßen Konzepte nicht zwingend die Verwendung einer organischen LED (OLED) erfordern. Es werden derzeit alternative flächige Leuchtmittel entwickelt, bei denen diese Gedanken ebenfalls zum Einsatz kommen können. Beispielsweise werden derzeit Leuchtmittel entwickelt, welche auf der Verwendung sog. elektrisch angeregter Quantendots beruhen. Diese Partikel bzw. Nanokristalle können sowohl in organische als auch anorganische Schichten eingebettet werden und emittieren nach ihrer Anregung wiederum Licht. Auch bei einem derartigen flächigen Leuchtmittel stellt sich die Problematik der einfachen aber zuverlässigen Kontaktierung sowie der effizienten Wärmeabführung, weshalb die erfindungsgemäßen Lösungen wiederum zu den bereits beschriebenen Vorteilen führen.

## Patentansprüche

1. Flächiger Leuchtkörper (10) mit:
einer Schichtanordnung (20) mit einer Abstrahloberfläche (20a) und einer dazu gegenüberliegenden rückseitigen Oberfläche (20b) und
einer Platine (30), wobei in der Platine (30) an gegenüberliegenden Randabschnitten eine Mehrzahl von Befestigungsmagneten (50a-c) zur Befestigung des flächigen Leuchtkörpers (10) an einer Trägerplatte oder in einer Fassung angeordnet sind, **dadurch gekennzeichnet, dass** an einem Randbereich der rückseitigen Oberfläche (20b) der Schichtanordnung Kontaktbereiche (22a-d) zur Kontaktierung der Schichtanordnung (20) angeordnet sind, und dass die Platine (30) vier oder mehr Kontaktbereiche (32a-d) an einer ersten, der Schichtanordnung (20) zugewandten Hauptoberfläche (30a) aufweist, wobei die Kontaktbereiche (32a-d) der Platine den Kontaktbereichen (22a-d) der Schichtanordnung (20) gegenüberliegen und mit Außenkontakten (34) an einer zweiten Hauptoberfläche (30b), die mit den Kontaktbereichen (32a-d) auf der ersten Hauptoberfläche (30a) elektrisch verbunden sind,
wobei die Kontaktbereiche (22a-d) der Schichtanordnung (20) jeweils mittels eines elektrischen Verbindungselements (40) mit dem zugehörigen Kontaktbereich (32a-d) der Platine (30) verbunden sind,
wobei die Schichtanordnung (20) eine als reguläres Vieleck ausgebildete, flächige Grundform aufweist, wobei die Kontaktbereiche der Schichtanordnung (20) an Eckpunkten des Vielecks ausgebildet sind.

2. Flächiger Leuchtkörper nach Anspruch 1, wobei die Befestigungsmagnete (50a-c) asymmetrisch oder mit einer vorgegebenen magnetischen Ausrichtung angeordnet sind, so dass der flächige Leuchtkörper (10) verpolungssicher an der Trägerplatte anbringbar oder in einer Fassung einsetzbar ist.

3. Flächiger Leuchtkörper nach Anspruch 1 oder 2, wobei die rückseitige Oberfläche (20b) der Schichtanordnung (20) mittels eines thermisch leitfähigen Klebstoffes (42) mit der der Schichtanordnung zugewandten Hauptoberfläche (30a) der Platine (30) verbunden ist.

4. Flächiger Leuchtkörper nach Anspruch 3, wobei der thermisch leitfähige Klebstoff (42) als ein Epoxidklebstoff ausgebildet ist.

5. Flächiger Leuchtkörper nach einem der vorhergehenden Ansprüche, wobei die Schichtanordnung eine Anodenschicht, eine Kathodenschicht und eine organische Licht-emittierende Schicht, die zwischen der Anodenschicht und der Kathodenschicht angeordnet ist, aufweist, und wobei die Kontaktbereiche (22a-d) an der rückseitigen Oberfläche der Schichtanordnung (20) Anodenkontaktbereiche, die die Anodenschicht kontaktieren, und Kathodenkontaktbereiche, die die Kathodenschichten kontaktieren, aufweisen.

6. Flächiger Leuchtkörper nach einem der vorhergehenden Ansprüche, wobei die elektrischen Verbindungselemente (40) als Druck-, Klemm-, Feder- oder Steckverbindungen oder als ein elektrisch leitfähiger Klebstoff ausgebildet sind.

7. Flächiger Leuchtkörper nach einem der vorhergehenden Ansprüche, wobei die Außenkontakte (34a-d) an der Platine (30) als Druck-, Klemm-, Feder- oder Steckkontakte zur elektrischen Verbindung mit einer Trägerplatte oder Fassung ausgebildet sind.

8. Anordnung von flächigen Leuchtkörpern mit:
einer Vielzahl von flächigen Leuchtkörpern (10) nach einem der Ansprüche 1 bis 7, wobei die flächigen Leuchtkörper zu einer regelmäßigen Anordnung kombiniert sind,
und wobei vorzugsweise die Vielzahl von flächigen Leuchtkörpern elektrisch parallel oder in Serie verschaltet ist.

## Claims

1. A flat luminous element (20) having:
a layer arrangement (20) with an emission surface (20a) and a rear-side surface (20b) opposite thereto and a circuit board (30), wherein in the circuit board (30) on opposite edge sections a plurality of fastening magnets (50a-c) for fastening the flat luminous element (10) are arranged on a support plate or in a socket, **characterized in that** at an edge area of the rear-side surface (20b) of the layer arrangement contact areas (22a-d) are arranged for contacting the layer arrangement (20), and that the circuit board (30) has four or more contact areas (32a-d) at a first main surface (30a) facing the layer arrangement (20), wherein the contact areas (32a-d) of the circuit board lie opposite the contact areas (22a-d) of the layer arrangement (20) and said circuit board having external contacts (34) at a second main surface (30b), which are connected electrically with the contact areas (32a-d) on the first main surface (30a),
wherein the contact areas (22a-d) of the layer arrangement (20) in each case are connected by means of an electrical connecting element (40) with the associated contact area (32a-d) of the circuit board (30),
wherein the layer arrangement (20) has a flat basic form designed as a regular polygon,
wherein the contact areas of the layer arrangement (20) are formed at corner points of the polygon.

2. A flat luminous element according to Claim 1, wherein the fastening magnets (50a-c) are arranged asymmetrically or with a predetermined magnetic alignment, so that the flat luminous element (10) can be attached to the support plate or can be inserted into a socket protected against polarity reversal.

3. A flat luminous element according to Claim 1 or 2, wherein the rear-side surface (20b) of the layer arrangement (20) is connected by means of a thermally conducive adhesive (42) with the main surface (30a) of the circuit board (30) facing the layer arrangement.

4. A flat luminous element according to Claim 3, wherein the thermally conductive adhesive (42) is designed as an epoxy adhesive.

5. A flat luminous element according to any one of the preceding claims, wherein the layer arrangement has an anode layer, a cathode layer and an organic light-emitting layer, which is arranged between the anode layer and the cathode layer, and wherein the contact areas (22a-d) at the rear-side surface of the layer arrangement (20) have anode contact areas, which contact the anode layer and cathode contact areas, which contact the cathode layers.

6. A flat luminous element according to any one of the preceding claims, wherein the electric connection elements (40) are designed as pressure-, clamping-, spring- or plug connections or as an electrically conductive adhesive.

7. A flat luminous element according to any one of the preceding claims, wherein the external contacts (34a-d) at the circuit board (30) are designed as pressure-, clamping-, spring- or plug contacts for the electrical connection with a support plate or socket.

8. An arrangement of flat luminous elements having:
A plurality of flat luminous elements (10) according to any one of Claims 1 to 7, wherein the flat luminous elements are combined to form a regular arrangement,
and wherein preferably the plurality of flat luminous elements is connected electrically in parallel or in series.

## Revendications

1. Corps lumineux (10) plat, avec :
une disposition en couche (20) avec une surface de rayonnement (20a) et une surface (20b) côté arrière opposée à la précédente
et
une platine (30), une pluralité d'aimants de fixation (50a-c) destinés à la fixation du corps lumineux (10) plat sur une plaque de support ou dans une douille étant disposés dans la platine (30) sur des tronçons de bord opposés, **caractérisé en ce que** des zones de contact (22a-d) destinées à la mise en contact de la disposition en couche (20) sont disposées sur une zone de bord de la surface (20b) côté arrière de la disposition en couche, et **en ce que** la platine (30) comporte quatre zones de contact (32a-d) ou davantage sur une première surface principale (30a) tournée vers la disposition en couche (20), les zones de contact (32a-d) de la platine étant opposées aux zones de contact (22a-d) de la disposition en couche (20), et avec des contacts extérieurs (34) sur une deuxième surface principale (30b) qui sont raccordés électriquement aux zones de contact (32a-d) sur la première surface principale (30a),
les zones de contact (22a-d) de la disposition en couche (20) étant raccordées à la zone de contact (32a-d) respective de la platine (30) respectivement au moyen d'un élément de raccordement (40) électrique,
la disposition en couche (20) comportant une forme de base plate constituée sous forme de polygone régulier, les zones de contact de la disposition en couche (20) étant constituées sur des sommets du polygone.

2. Corps lumineux plat selon la revendication 1, les aimants de fixation (50a-c) étant disposés de façon asymétrique ou avec une orientation magnétique prédéfinie de telle sorte que le corps lumineux (10) plat peut être mis en place sur la plaque de support sans risque d'inversion de polarité ou être introduit dans une douille.

3. Corps lumineux plat selon la revendication 1 ou 2, la surface (20b) côté arrière de la disposition en couche (20) étant, au moyen d'une colle (42) thermiquement conductrice, raccordée à la surface principale (30a) de platine (30) tournée vers la disposition en couche.

4. Corps lumineux plat selon la revendication 3, la colle (42) thermiquement conductrice étant constituée en tant que colle époxyde.

5. Corps lumineux plat selon l'une des revendications précédentes, la disposition en couche comportant une couche d'anode, une couche de cathode et une couche organique émettrice de lumière qui est disposée entre la couche d'anode et la couche de cathode, et les zones de contact (22a-d) comportant sur la surface côté arrière de la disposition en couche (20) des zones de contact d'anode qui entrent en contact avec la couche d'anode, et des zones de contact de cathode qui entrent en contact avec les couches de cathode.

6. Corps lumineux plat selon l'une des revendications précédentes, les éléments de raccordement électriques (40) étant constitués en tant que raccordements par pression, par serrage, par ressort ou par enfichage ou en tant que colle électriquement conductrice.

7. Corps lumineux plat selon l'une des revendications précédentes, les contacts extérieurs (34a-d) sur la platine (30) étant constitués en tant que contacts par pression, par serrage, par ressort ou par enfichage pour le raccordement électrique à une plaque de support ou douille.

8. Agencement de corps lumineux plats, avec :
une multiplicité de corps lumineux (10) plats selon l'une des revendications 1 à 7, les corps lumineux plats étant combinés pour former un agencement régulier,
et la multiplicité de corps lumineux plats étant de préférence montés électriquement en parallèle ou en série.
